# EUROPÄISCHE PATENTSCHRIFT

(11) **EP 0 477 415 B1**
(45) Veröffentlichungstag und Bekanntmachung des Hinweises auf die Patenterteilung: **20.03.1996**
(21) Anmeldenummer: 90118643.7
(22) Anmeldetag: 28.09.1990
(51) Int. Cl.: G01R 15/24, G02B 6/12

(54) **Optischer Stromwandler**
Optical current transducer
Transducteur optique de courant

(43) Veröffentlichungstag der Anmeldung: 01.04.1992
(73) Patentinhaber: ASEA BROWN BOVERI AG, CH-5401 Baden (CH)
(72) Erfinder: Stierlin, Roland, Dr., CH-5722 Gränichen (CH)

(56) Entgegenhaltungen:
- EP-A- 0 088 419
- EP-A- 0 356 670
- DE-A- 3 807 606
- INTERNATIONAL JOURNAL OF OPTOELECTRONICS Band 3, Nr. 5, 1988, Seiten 391-407; A.J. ROGERS: "Optical-fibre current measurement"
- JOURNAL OF LIGHTWAVE TECHNOLOGY Band LT-4, Nr. 10, Oktober
- 1986, Seiten 1580-1593, New York, NY, US; A. BRANDENBURG: "Stress in Ion- Exchanged Glass Waveguides"
- F &M FEINWERKTECHNIK & MESSTECHNIK Band 97, Nr. 10, Oktober 1989, Seiten 415-421, München, DE; K. GROSSKOPF: "Glasanwendung für integrierte Optik"

## Beschreibung

### TECHNISCHES GEBIET

Die vorliegende Erfindung bezieht sich auf das Gebiet der Strommesstechnik. Sie betrifft einen optischen Stromwandler, welcher zur Messung eines Stromes den Faraday-Effekt ausnutzt, umfassend
(a) ein Sensorelement mit einem optischen Eingang für die Einkopplung von Licht und wenigstens einem optischen Ausgang für die Auskopplung des Lichts;
(b) innerhalb des Sensorelements einen ringförmigen Wellenleiter, welcher den zu messenden Strom umschliesst und mit dem optischen Eingang und dem wenigstens einen optischen Ausgang optisch in Verbindung steht; und
(c) Mittel zur Messung der magneto-optischen Drehung der Polarisationsebene des Lichts in dem Wellenleiter.

Ein solcher Stromwandler ist z.B. aus der DE-A-31 16 149 bekannt.

### STAND DER TECHNIK

Optische Stromwandler, die zur Messung des Stromes den Faraday-Effekt in einem geeigneten Material, insbesondere einer Glasfaser, benutzen, sind aus einer Vielzahl von Veröffentlichungen bekannt. Stellvertretend hierfür sei auf die folgenden Druckschriften hingewiesen:
- "Magnetooptical current transformer. 1: Principles", A. Papp et al., Appl. Optics 19 (1980), S.3729-3734;
- "Magnetooptical current transformer. 2: Components", H. Aulich et al., Appl. Optics 19 (1980), S.3735-3740;
- "Magnetooptical current transformer. 3: Measurement", H. Harms et al., Appl. Optics 19 (1980), S.3741-3745; und
- "Magneto-optical fibre sensors for electrical industry: analysis of performances", S. Donati et al., IEE Proc. 135 (1988), S.372-382.

Es gibt dabei im Stand der Technik verschiedene Stromwandlerkonzepte, die sich hauptsächlich in der Art der Ausgestaltung des Sensorelements bzw. -kopfes unterscheiden. In vielen Fällen besteht das Sensorelement aus einer spulenartig aufgewickelten Glasfaser (siehe die o.g. Druckschriften). In anderen Fällen ist der Sensor als kompakter Glasblock ausgebildet, welcher den Strompfad umschliesst und im Inneren das Licht über verspiegelte Ecken um den Strompfad herum leitet (siehe dazu: "A new generation of current sensing", MOCT Technical Documentation Summary, Westinghouse ABB Power T+D Company, Electric Metering Systems, Raleigh, April 1989).

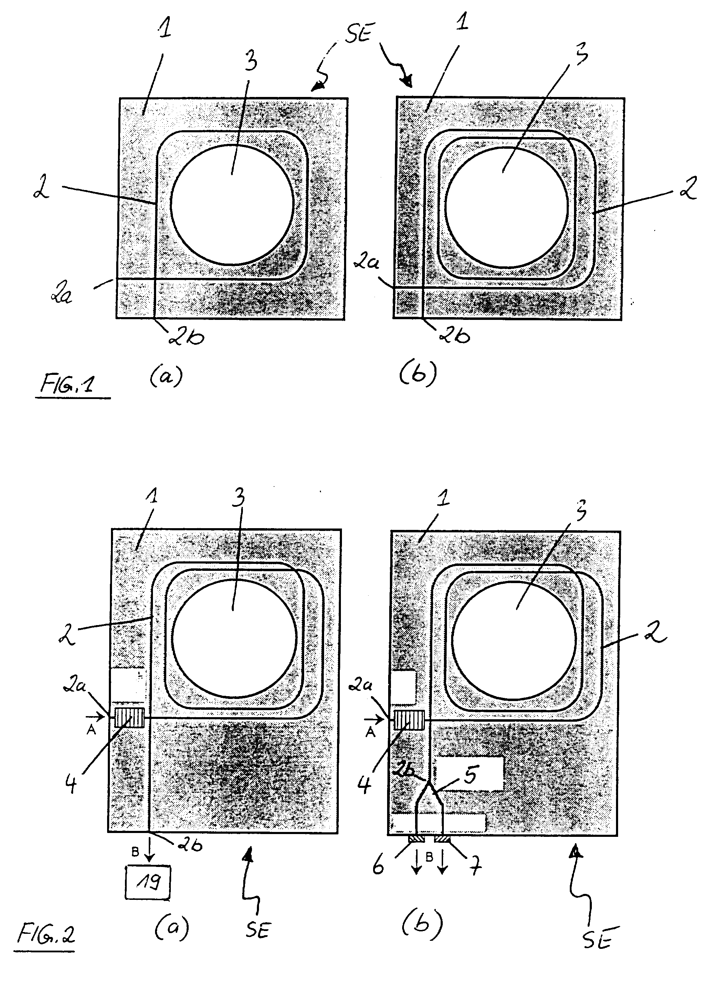

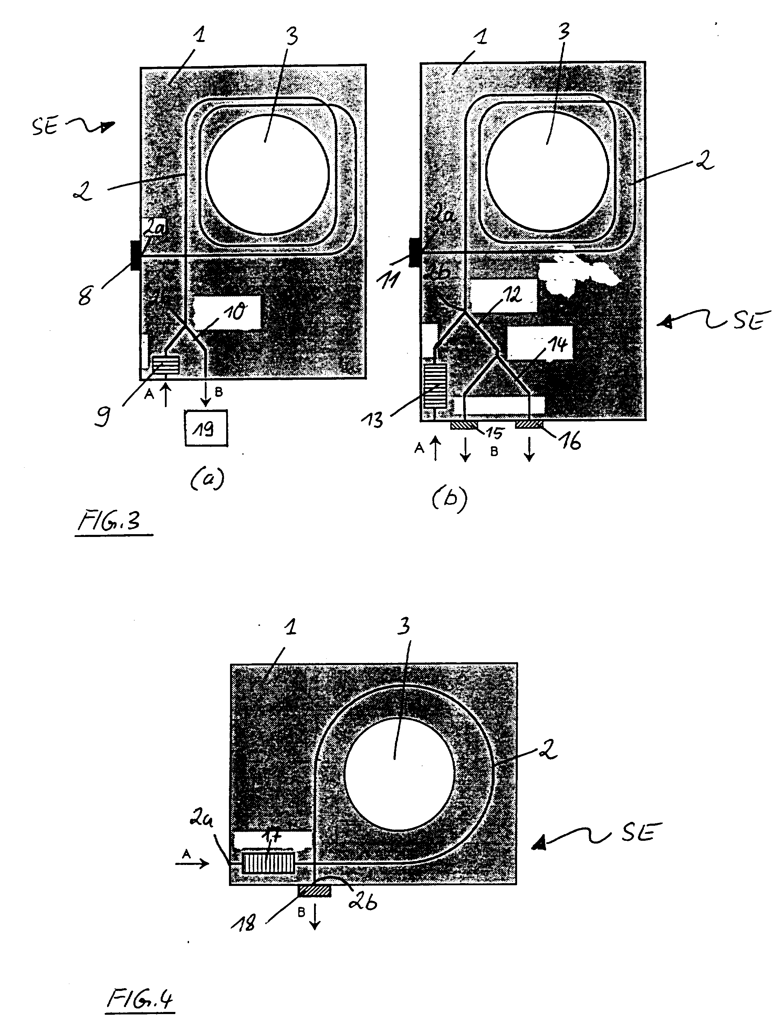

Für die Auswertung des Messsignals werden verschiedene Methoden eingesetzt: Da ist zum Einen die Einpolarisatormethode, bei welcher zur Analyse der Polarisation am Ausgang des Sensors ein einzelner Polarisator angeordnet ist (siehe dazu Fig.1 der DE-A-31 16 149). Andererseits wird aber auch die polarimetrische Detektionsmethode angewendet, bei der in einer polarimetrischen Detektionseinheit die Polarisationsanteile in zwei zueinander orthogonalen Richtungen bestimmt werden (siehe dazu Fig.3 des oben zitierten Artikels von S. Donati et al.).

Aus der Offenlegungsschrift DE-A-31 16 149 ist eine faseroptische Anordnung zur Messung eines elektrischen Stromes bekannt, bei welcher der Faraday-Effekt ausgenutzt wird. Die bei dieser Anordnung verwendete Glasfaser umschliesst den stromführenden Leiter mit mindestens einer Windung.

Die bisherigen Stromsensoren haben den Nachteil, dass sie entweder (wie bei der gewickelten Glasfaser) empfindlich auf externe Störungen des Wellenleiters, wie z.B. Vibrationen, Temperaturänderung, mechanischen Druck auf die Faser, Biegung der Faser, reagieren oder dass sie (wie beim verspiegelten Glasblock) aufwendig und teuer in der Herstellung sind.

### DARSTELLUNG DER ERFINDUNG

Aufgabe der vorliegenden Erfindung ist es nun, einen optischen Stromwandler zu schaffen, der unempfindlich gegenüber Umwelteinflüssen (Temperaturschwankungen, Vibrationen, etc.) ist, der geringe Abmessungen aufweist und der einfach herzustellen ist.

Die Aufgabe wird bei einem Wandler der eingangs genannten Art dadurch gelöst, dass das Sensorelement als ein flächiges Substrat mit einer in der Mitte liegenden, durchgehenden Öffnung für den zu messenden Strom ausgebildet ist, dass der Wellenleiter als integriert-optischer, in das Substrat vergrabener Single-Mode-Wellenleiter ausgeführt ist, und dass das Substrat zur Verringerung der Doppelbrechung auf der Seite des vergrabenen Wellenleiters mit einer zusätzlichen Abdeckung versehen ist.

Der Kern der Erfindung besteht darin, den Wellenleiter als in ein Substrat vergrabene Leitung auszuführen. Durch diese Integration in ein festes Substrat werden mechanische Spannungen vermieden, weil der Wellenleiter dauerhaft und sicher fixiert ist und vor allemnicht gebogen werden muss. Darüberhinaus können vorteilhafterweise weitere optische Elemente (Spiegel, Polarisatoren, Koppler etc.) in das Substrat integriert werden, so dass sich ein kompakter, robuster Sensor ergibt.

Ein erstes bevorzugtes Ausführungsbeispiel der Erfindung zeichnet sich dadurch aus, dass
(a) das Substrat aus einem Glas besteht; und
(b) der Wellenleiter durch Austausch von Ionen im Glas erzeugt worden ist.

Diese Methode der Integration ist bereits bei der Herstellung von Resonatoren für Gyroskope mit Erfolg angewendet worden und führt daher zu reproduzierbaren Ergebnissen.

Einen Sensor mit besonders geringer Doppelbrechung erhält man, wenn gemäss einem weiteren Ausführungsbeispiel der Erfindung das Substrat auf der Seite des vergrabenen Wellenleiters mit einer zusätzlichen Abdeckung versehen ist.

Weitere Ausführungsbeispiele ergeben sich aus den abhängigen Ansprüchen.

### KURZE BESCHREIBUNG DER ZEICHNUNG

Die Erfindung soll nachfolgend anhand von Ausführungsbeispielen im Zusammenhang mit der Zeichnung näher erläutert werden. Es zeigen (jeweils in Draufsicht)
- Fig.1a,b: zwei grundsätzliche Ausführungsformen eines Sensorelements nach der Erfindung mit einer (a) bzw. mehreren (b) Windungen des Wellenleiters;
- Fig.2a: ein erstes Ausführungsbeispiel eines erfindungsgemässen Sensorelements mit einem im Durchstrahlmodus betriebenen Wellenleiter, einem integrierten Polarisator am Eingang, und einer dem Ausgang folgenden polarimetrischen Detektionseinheit;
- Fig.2b: ein zweites Ausführungsbeispiel eines erfindungsgemässen Sensorelements mit einem im Durchstrahlmodus betriebenen Wellenleiter, einem integrierten Polarisator am Eingang, und einem integrierten Y-Koppler mit nachgeschalteten, zueinander orthogonalen Polarisatoren am Ausgang;
- Fig.3a: ein drittes Ausführungsbeispiel eines erfindungsgemässen Sensorelements mit einem im Reflexionsmodus betriebenen Wellenleiter, einem integrierten Y-Koppler, einem integrierten Polarisator am Eingang, und einer dem Ausgang folgenden polarimetrischen Detektionseinheit;
- Fig.3b: ein viertes Ausführungsbeispiel eines erfindungsgemässen Sensorelements mit einem im Reflexionsmodus betriebenen Wellenleiter, zwei integrierten Y-Kopplern, und einem integrierten Polarisator; und
- Fig.4: ein fünftes Ausführungsbeispiel eines erfindungsgemässen Sensorelements mit einem im Durchstrahlmodus betriebenen Wellenleiter, einem integrierten Polarisator am Eingang, und einem einzelnen Polarisator am Ausgang.

### WEGE ZUR AUSFÜHRUNG DER ERFINDUNG

Zwei grundsätzliche Ausführungsformen eines Sensorelements nach der Erfindung sind in Fig.1a und 1b in Draufsicht wiedergegeben. Das Sensorelement SE besteht im wesentlichen aus einem flächigen Substrat 1 mit einer in der Mitte angeordneten, durchgehenden Oeffnung 3. Durch diese Oeffnung 3 wird im Anwendungsfall der zu messende Strom geleitet.

Um die Oeffnung 3 herum verläuft ein Wellenleiter 2, welcher die Oeffnung 3 in einer (Fig.1a) oder mehreren (Fig.1b) Windungen vollständig umschliesst. Der Wellenleiter 2 weist zwei Wellenleiterenden 2a und 2b auf, an denen, je nach Art der Mess- und Auswertemethode, Licht ein- und ausgekoppelt oder reflektiert werden kann.

Eine wichtige Besonderheit des Wellenleiters 2, die in den Figuren nicht explizit zu erkennen ist, besteht nun darin, dass es sich hierbei um einen integriert-optischen (io) Wellenleiter handelt, der durch Vergraben in das Substrat 1 hergestellt worden ist. Der vergrabene io-Wellenleiter 2 weist vorzugsweise eine Doppelbrechung (DB) von DB < 10⁻⁵, insbesondere von DB < 10⁻⁶ auf.

Ueber Herstellung und Eigenschaften von integriert-optischen Ringwellenleitern in Glas ist in der Literatur zwar bereits berichtet worden. Diese Ringstrukturen sind allerdings ausschliesslich als Resonatoren ausgeführt, z.B. für die Anwendung in optischen Gyroskopen (siehe dazu: "Characteristics of an integrated optics ring resonator fabricated in glass", K. Honda et al., IEEE J. of Light-wave Technology LT-2 (1984), S.714-719; und "Waveguide ring resonators in glass for optical gyros", W. Bernhard et al., Proc. DGON (1986), S.7.0-7.15).

Durch die Optimierung der Gläser und des Herstellungsprozesses ist es darüberhinaus gelungen, vergrabene Single-Mode-Wellenleiter herzustellen, die eine Doppelbrechung von DB ≤ 10⁻⁴ aufweisen (Messgenauigkeit ist ±10⁻⁴; siehe dazu: "Integrierte Optik in Glas", L. Ross, MIOP 1988).

Aus der Theorie der optischen Stromsensoren ist es andererseits bekannt, dass bei dieser Anwendung die Doppelbrechung entlang dem Lichtweg um den stromführenden Leiter nicht zu gross sein darf (siehe dazu: "Optical-fibre current measurement", A. J. Rogers, Int. J. of Optoelectronics 3 (1988), S.391-407).

Es ist bisher nicht erwogen worden, derartige vergrabene Wellenleiter in einem Stromsensor einzusetzen, der nach dem Prinzip des Faraday-Effekts arbeitet, weil hierzu eine Doppelbrechung im Wellenleiter von DB ≤ 10⁻⁶ notwendig ist.

Interne Messungen bei der Anmelderin haben nun ergeben, dass die Doppelbrechung DB in vergrabenen io-Single-Mode-Wellenleitern klein ist (DB ≈ 10⁻⁵). Durch geeignete Massnahmen (siehe unten) kann sie weiter reduziert werden auf DB ≤ 10⁻⁶. Mit Wellenleitern, deren Doppelbrechung geringer ist als DB ≈ 10⁻⁶, können Ringwellenleiter geformt werden, die für eine optische Strommessung mittels Faraday-Effekts gut geeignet sind.

Das Substrat 1 besteht dabei vorzugsweise aus einem Glas, in welchem der Wellenleiter 2 durch Austausch von Ionen erzeugt worden ist. Innerhalb dieses Austausches werden bestimmte Ionen des ursprünglichen Glases durch andere Ionen ersetzt, die das atomare Glasgefüge und den Brechungsindex verändern.

Beispielsweise wird für das Substrat 1 ein Glas verwendet, welches SiO₂, B₂O₃, Al₂O₃, Na₂O und F⁻ enthält, mit einem Na₂O-Anteil von 12,5 Mol-%, und welches insbesondere z.B. von der Firma Schott (Mainz) unter der Bezeichnung BGG 31 im Handel angeboten wird. Der Wellenleiter 2 wird dann dadurch erzeugt, dass Na⁺-Ionen im Glas durch Ag⁺-Ionen ausgetauscht werden.

Besonders gering wird die kritische Doppelbrechung des io-Wellenleiters 2, wenn das Substrat 1 auf der Seite des vergrabenen Wellenleiters 2 mit einer zusätzlichen, geeigneten Abdeckung versehen ist. Vorzugsweise besteht die zusätzliche Abdeckung aus einer Kunststoffbeschichtung, oder sie wird durch ein weiteres Glas-Substrat gebildet, welches auf das Substrat 2 aufgeklebt, aufgedampft oder aufgesprengt worden ist. Wichtig ist dabei, dass der Brechungsindex der Abdeckung gleich dem Brechungsindex des Substrats 2 oder etwas geringer ist.

Besonders gering wird die kritische Doppelbrechung des io-Wellenleiters 2 auch, wenn die Elliptizität (Maskenbreite) und die Vergrabetiefe des Wellenleiters so aufeinander abgestimmt werden, dass die damit verbundene geometrische Doppelbrechung die stress-induzierte Doppelbrechung kompensiert.

Besonders kompakt und robust wird der Stromwandler, wenn darüberhinaus die Mittel zur Messung der magneto-optischen Drehung zumindest teilweise in das Sensorelement (SE) integriert sind.

Während in Fig.1a und b lediglich die Grundform eines Sensorelements SE nach der Erfindung wiedergegeben ist, zeigen die Figuren 2 bis 4 Ausführungsformen von Sensorelementen SE mit zusätzlichen, integrierten Elementen für die Messung des Faraday-Effekts in dem Wellenleiter 2. Jedes dieser Sensorelemente SE weist einen optischen Eingang A für die Einkopplung des Lichts und wenigstens einen optischen Ausgang B für die Auskopplung des Lichts auf. Die Einkopplung kann dabei z.B. über eine zuführende Glasfaser oder eine direkt angekoppelte Halbleiter-Lichtquelle erfolgen.

Bei den Ausführungsformen gemäss Fig.2a und b sowie Fig.4 bildet das eine Wellenleiterende 2a direkt den optischen Eingang A des Sensorelements SE. An diesem einen Wellenleiterende 2a ist vorzugsweise hinter dem optischen Eingang A ein erster, in das Substrat 1 integrierter Polarisator 4 bzw. 17 angeordnet, welcher das in den optischen Eingang A eintretende Licht linear polarisiert.

Das linear polarisierte Licht läuft dann in dem Wellenleiter 2 um die Oeffnung 3 herum, durch welche der zu messende Strom fliesst. Am anderen Wellenleiterende 2b wird die durch den Strom bewirkte Drehung der Polarisationsebene analysiert und gemessen.

Diese Messung kann dadurch geschehen, dass das andere Wellenleiterende 2b direkt mit nur einem optischen Ausgang B verbunden ist und das Licht von diesem optischen Ausgang B in eine separate, herkömmliche polarimetrische Detektionseinheit 19 überführt wird (Fig.2a).

Die Messung kann aber auch in der Weise realisiert werden, dass das andere Wellenleiterende 2b über einen ausgangsseitigen, in das Substrat 1 integrierten Y-Koppler 5 mit zwei optischen Ausgängen B verbunden ist. An den beiden optischen Ausgängen B sind dann ein zweiter und dritter Polarisator 6 bzw. 7 angeordnet, die mit ihrer Polarisationsebene orthogonal zueinander und gegenüber dem ersten Polarisator 4 um ±45° verdreht eingestellt sind. Die Lichtleistung an den beiden Ausgängen B wird hinter den Polarisatoren 6 und 7 entweder direkt oder über zwei Glasfasern gemessen (Fig.2b).

Die Messung kann schliesslich auch dadurch erfolgen, dass das andere Wellenleiterende 2b direkt mit nur einem optischen Ausgang B verbunden ist und das Licht an diesem optischen Ausgang B durch einen zweiten Polarisator 18 geschickt wird, dessen Polarisationsebene gegenüber dem ersten Polarisator 17 um 45° verdreht ist (Fig.4; Einpolarisatormethode). Der zweite Polarisator 18 kann dabei entweder (wie in der Figur gezeigt) ein diskretes Element sein, oder anstelle des ersten Polarisators 17 in das Substrat 1 integriert werden.

Bei den Ausführungsformen gemäss Fig.3a und 3b wird die Drehung der Polarisationsebene in Reflexion gemessen. Zu diesem Zweck ist das eine Wellenleiterende 2a mit einem Spiegel 8 bzw. 11 versehen. Das andere Wellenleiterende 2b steht über einen in das Substrat 1 integrierten, eingangsseitigen Y-Koppler 10 bzw. 12 mit dem optischen Eingang A und dem wenigstens einen optischen Ausgang B in Verbindung.

In beiden Fällen kann in dem einen Zweig des eingangsseitigen Y-Kopplers 10 bzw. 12 hinter dem optischen Eingang A ein erster, in das Substrat 1 integrierter Polarisator 9 bzw. 13 angeordnet sein, der - wie bei den Sensorelementen gemäss Fig.2a, 2b und 4 - das eingekoppelte Licht linear polarisiert.

In der Ausführungsform gemäss Fig.3a ist nur ein optischer Ausgang B vorhanden, der mit dem anderen Zweig des eingangsseitigen Y-Kopplers 10 in Verbindung steht. Das Licht kann, nachdem es den Wellenleiter 2 in beiden Richtungen durchlaufen hat, dort ausgekoppelt und wiederum auf eine externe polarimetrische Detektionseinheit 19 gegeben werden; oder aber es wird am Ausgang B ein weiterer Polarisator angeordnet, der unter 45° zu dem ersten Polarisator 9 steht, und die Einpolarisatormethode kommt zur Anwendung.

In der Ausführungsform gemäss Fig.3b sind zwei optische Ausgänge B vorhanden. Der andere Zweig des eingangsseitigen Y-Kopplers 12 ist mit diesen beiden optischen Ausgängen B über einen ausgangsseitigen, in das Substrat 1 integrierten Y-Koppler 14 optisch verbunden. Das reflektierte Licht wird hier im eingangsseitigen Y-Koppler 12 ausgekoppelt, im ausgangsseitigen Y-Koppler 14 in zwei Komponenten aufgeteilt und mittels eines zweiten und dritten Polarisators 15 bzw. 16 analysiert, die orthogonal zueinander und gegenüber dem ersten Polarisator 13 um ±45° verdreht an den beiden optischen Ausgängen B angeordnet sind.

Die bei allen Ausführungsformen verwendeten integrierten Y-Koppler 5, 10, 12 und 14 können in der gleichen Technik realisiert werden wie der Wellenleiter 2 selbst, d.h. durch Ionenaustausch im Glassubstrat. Die bei den reflektiv arbeitenden Sensorelementen (Fig.3a und b) benötigten Spiegel können dadurch realisiert werden, dass der Wellenleiter 2 an den Rand des Substrats 1 geführt und dort ein Spiegel z.B. aufgedampft oder aufgeklebt wird (Spiegel 8 in Fig.3b). Ist dies nicht möglich oder nicht zweckmässig, kann ein Spiegel auch durch ein Reflexionsgitter oder durch Einätzen oder Einbohren einer Vertiefung in das Substrat 1 realisiert werden.

Die Ausführungsformen des Sensorelements SE gemäss Fig.2a bis und mit Fig.4 können auch als optische Resonatoren eingesetzt werden. In diesem Fall wird der eingangsseitige, erste Polarisator 4, 9, 13 bzw. 17 weggelassen. Der optische Eingang A und der optische Ausgang B werden beide verspiegelt (Verspiegelung < 100 %). Ein derart abgewandeltes Sensorelement SE ersetzt dann den Glasfaserhelixresonator in den Messanordnungen gemäss der Europäischen Patentanmeldung EP-A-0 356 670.

## Patentansprüche

1. Optischer Stromwandler, welcher zur Messung eines Stromes den Faraday-Effekt ausnutzt, umfassend
(a) ein Sensorelement (SE) mit einem optischen Eingang (A) für die Einkopplung von Licht und wenigstens einem optischen Ausgang (B) für die Auskopplung des Lichts;
(b) innerhalb des Sensorelements (SE) einen ringförmigen Wellenleiter (2), welcher den zu messenden Strom mit wenigstens einer Windung umschliesst und welcher mit dem optischen Eingang (A) und dem wenigstens einen optischen Ausgang (B) optisch in Verbindung steht;
(c) Mittel zur Messung der magneto-optischen Drehung der Polarisationsebene des Lichts in dem Wellenleiter (2);
dadurch gekennzeichnet,
(d) dass das Sensorelement (SE) als ein flächiges Substrat (1) mit einer in der Mitte liegenden, durchgehenden Öffnung (3) für den zu messenden Strom ausgebildet ist,
(e) dass der Wellenleiter (2) als integriert-optischer, in das Substrat (1) vergrabener Single-Mode-Wellenleiter ausgeführt ist, und
(f) dass das Substrat (1) zur Verringerung der Doppelbrechung auf der Seite des vergrabenen Wellenleiters (2) mit einer zusätzlichen Abdeckung versehen ist.

2. Optischer Stromwandler nach Anspruch 1, dadurch gekennzeichnet,
- dass der Wellenleiter (2) eine Doppelbrechung von DB ≤ 10⁻⁶ aufweist.

3. Optischer Stromwandler nach Anspruch 2, dadurch gekennzeichnet,
(a) dass das Substrat (1) aus einem Glas besteht, und
(b) dass der Wellenleiter (2) durch Austausch von Ionen im Glas erzeugt worden ist.

4. Optischer Stromwandler nach Anspruch 3, dadurch gekennzeichnet,
(a) dass das Glas des Substrats (2) SiO₂, B₂O₃, Al₂O₃, Na₂O und F⁻ enthält, mit einem Na₂O-Anteil von 12,5 Mol-%, insbesondere Glas vom Typ BGG 31 der Firma Schott ist, und
(b) dass der Wellenleiter (2) dadurch erzeugt worden ist, dass Na⁺-Ionen im Glas durch Ag⁺-Ionen ausgetauscht worden sind.

5. Optischer Stromwandler nach Anspruch 1, dadurch gekennzeichnet,
- dass die zusätzliche Abdeckung aus einer Kunststoffbeschichtung besteht, oder durch ein weiteres Glas-Substrat gebildet wird, welches auf das Substrat (2) aufgeklebt, aufgedampft oder aufgesprengt worden ist.

6. Optischer Stromwandler nach Anspruch 3, dadurch gekennzeichnet,
- dass die Elliptizität und die Vergrabetiefe des Wellenleiters (2) so aufeinander abgestimmt werden, dass die damit verbundene geometrische Doppelbrechung die stress-induzierte Doppelbrechung kompensiert.

7. Optischer Stromwandler nach Anspruch 1, dadurch gekennzeichnet,
- dass die Mittel zur Messung der magneto-optischen Drehung zumindest teilweise in das Sensorelement (SE) integriert sind.

8. Optischer Stromwandler nach Anspruch 1, dadurch gekennzeichnet,
(a) dass der Wellenleiter (2) zwei Wellenleiterenden (2a,b) aufweist,
(b) dass das eine Wellenleiterende (2a) den optischen Eingang (A) des Sensorelements (SE) bildet, und
(c) dass das andere Wellenleiterende (2b) mit dem wenigstens einen optischen Ausgang (B) des Sensorelements (SE) optisch in Verbindung steht.

9. Optischer Stromwandler nach Anspruch 8, dadurch gekennzeichnet,
(a) dass am einen Wellenleiterende (2a) hinter dem optischen Eingang (A) ein erster, in das Substrat (1) integrierter Polarisator (4,17) angeordnet ist,
(b) dass nur ein optischer Ausgang (B) vorhanden ist, und
(c) dass das andere Wellenleiterende (2b) direkt mit dem einen optischen Ausgang (B) optisch verbunden ist.

10. Optischer Stromwandler nach Anspruch 9, dadurch gekennzeichnet,
(a) dass die Mittel zur Messung der magneto-optischen Drehung der Polarisationsebene eine polarimetrische Detektionseinheit (19) umfassen, und
(b) dass die polarimetrische Detektionseinheit (19) hinter dem einen optischen Ausgang (B) angeordnet ist. (Fig.2a)

11. Optischer Stromwandler nach Anspruch 9, dadurch gekennzeichnet,
(a) dass die Mittel zur Messung der magneto-optischen Drehung der Polarisationsebene einen zweiten Polarisator (18) umfassen,
(b) dass der zweite Polarisator (18) gegenüber dem ersten Polarisator (17) um 45° verdreht ist, und
(c) dass der zweite Polarisator (18) am anderen Wellenleiterende (2b) angeordnet ist. (Fig.4)

12. Optischer Stromwandler nach Anspruch 11, dadurch gekennzeichnet,
- dass der zweite Polarisator (18) anstelle des ersten Polarisators (17) in das Substrat (1) integriert ausgeführt ist.

13. Optischer Stromwandler nach Anspruch 8, dadurch gekennzeichnet,
(a) dass am einen Wellenleiterende (2a) hinter dem optischen Eingang (A) ein erster, in das Substrat (1) integrierter Polarisator (4,17) angeordnet ist,
(b) dass zwei optische Ausgänge (B) vorhanden sind,
(c) dass das andere Wellenleiterende (2b) mit den beiden optischen Ausgängen (B) über einen ausgangsseitigen, in das Substrat (1) integrierten Y-Koppler (5) optisch verbunden ist,
(d) dass die Mittel zur Messung der magneto-optischen Drehung der Polarisationsebene einen zweiten und dritten Polarisator (6,7) umfassen, und
(e) dass der zweite und dritte Polarisator (6,7) orthogonal zueinander und gegenüber dem ersten Polarisator (4) um ±45° verdreht an den beiden optischen Ausgängen (B) angeordnet sind. (Fig.2b)

14. Optischer Stromwandler nach Anspruch 1, dadurch gekennzeichnet,
(a) dass der Wellenleiter (2) zwei Wellenleiterenden (2a,b) aufweist,
(b) dass das eine Wellenleiterende (2a) mit einem Spiegel (8,11) versehen ist, und
(c) dass das andere Wellenleiterende (2b) mit dem optischen Eingang (A) und dem wenigstens einen optischen Ausgang (B) des Sensorelements (SE) über einen eingangsseitigen, in das Substrat (1) integrierten Y-Koppler (10,12) optisch verbunden ist.

15. Optischer Stromwandler nach Anspruch 14, dadurch gekennzeichnet,
(a) dass im einen Zweig des eingangsseitigen Y-Kopplers (10) hinter dem optischen Eingang (A) ein erster, in das Substrat (1) integrierter Polarisator (9) angeordnet ist,
(b) dass nur ein optischer Ausgang (B) vorhanden ist,
(c) dass der andere Zweig des eingangsseitigen Y-Kopplers (10) direkt mit dem einen optischen Ausgang (B) optisch verbunden ist,
(d) dass die Mittel zur Messung der magneto-optischen Drehung der Polarisationsebene eine polarimetrische Detektionseinheit (19) umfassen, und
(e) dass die polarimetrische Detektionseinheit (19) hinter dem einen optischen Ausgang (B) angeordnet ist. (Fig.3a)

16. Optischer Stromwandler nach Anspruch 14, dadurch gekennzeichnet,
(a) dass im einen Zweig des eingangsseitigen Y-Kopplers (10) hinter dem optischen Eingang (A) ein erster, in das Substrat (1) integrierter Polarisator (9) angeordnet ist,
(b) dass nur ein optischer Ausgang (B) vorhanden ist,
(c) dass der andere Zweig des eingangsseitigen Y-Kopplers (10) direkt mit dem einen optischen Ausgang (B) optisch verbunden ist,
(d) dass die Mittel zur Messung der magneto-optischen Drehung der Polarisationsebene einen weiteren Polarisator umfassen, und
(e) dass der weitere Polarisator gegenüber dem ersten Polarisator (9) um 45° verdreht und hinter dem einen optischen Ausgang (B) angeordnet ist.

17. Optischer Stromwandler nach Anspruch 14, dadurch gekennzeichnet,
(a) dass im einen Zweig des eingangsseitigen Y-Kopplers (12) hinter dem optischen Eingang (A) ein erster, in das Substrat (1) integrierter Polarisator (13) angeordnet ist,
(b) dass zwei optische Ausgänge (B) vorhanden sind,
(c) dass der andere Zweig des eingangsseitigen Y-Kopplers (12) mit den beiden optischen Ausgängen (B) über einen ausgangsseitigen, in das Substrat (1) integrierten Y-Koppler (14) optisch verbunden ist,
(d) dass die Mittel zur Messung der magneto-optischen Drehung der Polarisationsebene einen zweiten und dritten Polarisator (15,16) umfassen, und
(e) dass der zweite und dritte Polarisator (15,16) orthogonal zueinander und gegenüber dem ersten Polarisator (13) um ±45° verdreht an den beiden optischen Ausgängen (B) angeordnet sind. (Fig.3b)

18. Optischer Stromwandler nach Anspruch 1, dadurch gekennzeichnet,
(a) dass der Wellenleiter (2) zwei Wellenleiterenden (2a,b) aufweist,
(b) dass beide Wellenleiterenden (2a,b) verspiegelt sind, und
(c) dass der Wellenleiter (2) als Resonator verwendet wird.

## Claims

1. Optical current transformer which makes use of the Faraday effect for the purpose of measuring a current, comprising
(a) a sensor element (SE) having an optical entrance (A) for coupling in light and at least one optical exit (B) for coupling out the light;
(b) within the sensor element (SE), an annular waveguide (2) which encloses the current to be measured with at least one winding and which is optically connected to the optical entrance (A) and the at least one optical exit (B);
(c) means for measuring the magneto-optical rotation of the plane of polarization of the light in the waveguide (2);
characterized in that
(d) the sensor element (SE) is designed as a flat substrate (1) with a continuous opening (3), situated at the centre, for the current to be measured,
(e) in that the waveguide (2) is designed as an integrated-optics single-mode waveguide embedded in the substrate (1), and
(f) in that in order to reduce the birefringence the substrate (1) is provided with an additional covering on the side of the embedded waveguid (2).

2. Optical current transformer according to Claim 1, characterized in that
- the waveguide (2) exhibits a birefringence of DB ≤ 10⁻⁶.

3. Optical current transformer according to Claim 2, characterized in that
(a) the substrate (1) consists of a glass, and
(b) in that the waveguide (2) has been generated by the exchange of ions in the glass.

4. Optical current transformer according to Claim 3, characterized in that
(a) the glass of the substrate (2) contains SiO₂, B₂O₃, Al₂O₃, Na₂O and F⁻, with an Na₂O proportion of 12.5 mol %, especially glass of the type BGG 31 from the company Schott, and
(b) in that the waveguide (2) has been generated by replacing Na⁺ ions in the glass by Ag⁺ ions.

5. Optical current transformer according to Claim 3, characterized in that
- the additional covering consists of a plastic material coating, or is formed by a further glass substrate which has been adhesively bonded, vaporized or sprayed onto the substrate (2).

6. Optical current transformer according to Claim 3, characterized in that
- the ellipticity and the depth of embedding of the waveguide (2) are coordinated with one another so that the geometric birefringence associated therewith compensates the stress-induced birefringence.

7. Optical current transformer according to Claim 1, characterized in that
- the means for the measurement of the magneto-optical rotation are at least partially integrated into the sensor element (SE).

8. Optical current transformer according to Claim 1, characterized in that
(a) the waveguide (2) exhibits two waveguide ends (2a, b),
(b) in that one (2a) of the waveguide ends forms the optical entrance (A) of the sensor element (SE), and
(c) in that the other waveguide end (2b) is optically connected to the at least one optical exit (B) of the sensor element (SE).

9. Optical current transformer according to Claim 9, characterized in that
(a) at one (2a) of the waveguide ends behind the optical entrance (A) there is disposed a first polarizer (4, 17) integrated into the substrate (1),
(b) in that only one optical exit (B) is present, and
(c) in that the other waveguide end (2b) is directly optically connected to the one optical exit (B).

10. Optical current transformer according to Claim 9, characterized in that
(a) the means for the measurement of the magneto-optical rotation of the plane of polarization comprise a polarimetric detection unit (19), and
(b) in that the polarimetric detection unit (19) is disposed behind the one optical exit (B). (Fig. 2a)

11. Optical current transformer according to Claim 9, characterized in that
(a) the means for the measurement of the magneto-optical rotation of the plane of polarization comprise a second polarizer (18),
(b) in that the second polarizer (18) is rotated through 45° in relation to the first polarizer (17), and
(c) in that the second polarizer (18) is disposed at the other waveguide end (2b) (Fig. 4)

12. Optical current transformer according to Claim 11, characterized in that
- the second polarizer (18) is designed to be integrated into the substrate (1) in place of the first polarizer (17).

13. Optical current transformer according to Claim 8, characterized in that
(a) at one (2a) of the waveguide ends behind the optical entrance (A) there is disposed a first polarizer (4, 17) integrated into the substrate (1),
(b) in that two optical exits (B) are present,
(c) in that the other waveguide end (2b) is optically connected to the two optical exits (B) via an exit-side Y coupler (5) integrated into the substrate (1),
(d) in that the means for the measurement of the magneto-- optical rotation of the plane of polarization comprise a second and third polarizer (6, 7),
(e) in that the second and third polarizers (6, 7) are disposed so as to be orthogonal to one another and rotated through ±45° in relation to the first polarizer (4), at the two optical exits (B). (Fig. 2b)

14. Optical current transformer according to Claim 1, characterized in that
(a) the waveguide (2) exhibits two waveguide ends (2a, b),
(b) in that one (2a) of the waveguide ends is provided with a mirror (8, 11), and
(c) in that the other waveguide end (2b) is optically connected to the optical entrance (A) and the at least one optical exit (B) of the sensor element (SE) via an entrance-side Y coupler (10, 12) integrated into the substrate (1).

15. Optical current transformer according to Claim 14, characterized in that
(a) in one of the branches of the entrance-side Y coupler (10) behind the optical entrance (A) there is disposed a first polarizer (9) integrated into the substrate (1),
(b) in that only one optical exit (B) is present,
(c) in that the other branch of the entrance-side Y coupler (10) is directly optically connected to the one optical exit (B),
(d) in that the means for the measurement of the magneto-optical rotation of the plane of polarization comprise a polarimetric detection unit (19), and
(e) in that the polarimetric detection unit (19) is disposed behind the one optical exit (B). (Fig. 3a)

16. Optical current transformer according to Claim 14, characterized in that
(a) in one of the branches of the entrance-side Y coupler (10) behind the optical entrance (A) there is disposed a first polarizer (9) integrated into the substrate (1),
(b) in that only one optical exit (B) is present,
(c) in that the other branch of the entrance-side Y coupler (10) is directly optically connected to the one optical exit (B),
(d) in that the means for the measurement of the magneto-optical rotation of the plane of polarization comprise a further polarizer, and
(e) in that the further polarizer is rotated through 45° in relation to the first polarizer (9) and is disposed behind the one optical exit (B).

17. Optical current transformer according to Claim 14, characterized in that
(a) in one of the branches of the entrance-side Y coupler (12) behind the optical entrance (A) there is disposed a first polarizer (13) integrated into the substrate (1),
(b) in that two optical exits (B) are present,
(c) in that the other branch of the entrance-side Y coupler (12) is optically connected to the two optical exits (B) via an exit-side Y coupler (14) integrated into the substrate (1),
(d) in that the means for the measurement of the magneto-optical rotation of the plane of polarization comprise a second and third polarizer (15, 16), and
(e) in that the second and third polarizers (15, 16) are disposed so as to be orthogonal to one another and rotated through ±45° in relation to the first polarizer (13), at the two optical exits (B). (Fig. 3b)

18. Optical current transformer according to Claim 1, characterized in that
(a) the waveguide (2) exhibits two waveguide ends (2a, b),
(b) in that the two waveguide ends (2a, b) are mirror-coated, and
(c) in that the waveguide (2) is employed as a resonator.

## Revendications

1. Transducteur optique de courant, lequel utilise l'effet de Faraday pour mesurer un courant, comprenant
(a) un élément capteur (SE) avec une entrée optique (A) pour l'injection de la lumière et au moins une sortie optique (B) pour le découplage de la lumière ;
(b) à l'intérieur de l'élément capteur (SE), un guide d'ondes (2) en forme d'anneau, lequel entoure le courant à mesurer avec au moins un enroulement et se trouve en liaison optique avec l'entrée optique (A) et avec ladite au moins une sortie optique (B) ; et
(c) un dispositif destiné à mesurer la rotation magnéto-optique du champ de polarisation de la lumière dans le guide d'ondes (2) ;
caractérisé par le fait
(d) que l'élément capteur (SE) est réalisé sous la forme d'un substrat (1) plan avec une ouverture (3) traversante disposée au centre pour le courant à mesurer,
(e) que le guide d'ondes (2) est réalisé sous la forme d'un guide d'onde monomodal optique intégré dans le substrat (1),
(f) et que le substrat (1) est muni d'un recouvrement supplémentaire destiné à réduire la biréfringence du côté du guide d'ondes (2) intégré.

2. Transducteur optique de courant conforme à la revendication 1, caractérisé par le fait
- que le guide d'ondes (2) présente une biréfringence DB ≤ 10⁻⁶.

3. Transducteur optique de courant conforme à la revendication 2, caractérisé par le fait
(a) que le substrat (1) est composé d'un verre, et
(b) que le guide d'ondes (2) a été généré par échange ionique dans le verre.

4. Transducteur optique de courant conforme à la revendication 3, caractérisé par le fait
(a) que le verre du substrat (2) contient du SiO₂, B₂O₃, Al₂O₃, Na₂O et du F⁻, avec une proportion de 12,5 % Mol. de NA₂O, notamment du verre du type BBG 31 de la société Schott, et
(b) que le guide d'ondes (2) est généré en remplaçant les ions Na⁺ dans le verre par des ions Ag⁺.

5. Transducteur optique de courant conforme à la revendication 1, caractérisé par le fait
- que le recouvrement supplémentaire est composé d'un revêtement en plastique, ou alors il est formé d'un autre substrat en verre qui a été collé, métallisé sous vide ou appliqué par force directement sur le substrat (2).

6. Transducteur optique de courant conforme à la revendication 3, caractérisé par le fait
- que l'ellipticité et la profondeur d'intégration du guide d'ondes (2) sont accordées l'une sur l'autre de telle façon que la biréfringence géométrique qui y est liée compense la biréfringence induite par la contrainte.

7. Transducteur optique de courant conforme à la revendication 1, caractérisé par le fait
- que les dispositifs de mesure de la rotation magnéto-optique sont au moins en partie intégrés dans l'élément capteur (SE).

8. Transducteur optique de courant conforme à la revendication 1, caractérisé par le fait
(a) que le guide d'ondes (2) présente deux extrémités de guide d'ondes (2a, 2b),
(b) que l'une des extrémités du guide d'onde (2a) forme l'entrée optique (A) de l'élément capteur (SE), et
(c) que l'autre extrémité (2b) et reliée avec ladite au moins une sortie optique (B) de l'élément capteur (SE).

9. Transducteur optique de courant conforme à la revendication 8, caractérisé par le fait
(a) qu'à l'une des extrémités du guide d'ondes (2a), derrière l'entrée optique (A), est disposé un premier polariseur (4,17) intégré dans le substrat,
(b) qu'il n'y a qu'une seule sortie optique (B), et
(c) que l'autre extrémité du guide d'ondes (2b) est reliée optiquement directement avec la sortie optique (B).

10. Transducteur optique de courant conforme à la revendication 9, caractérisé par le fait
(a) que les dispositifs destinés à mesurer la rotation magnéto-optique du plan de polarisation comprennent un module de détection polarimétrique (19), et
(b) que le module de détection polarimétrique (19) est disposé derrière la sortie optique (B). (Figure 2a)

11. Transducteur optique de courant conforme à la revendication 9, caractérisé par le fait
(a) que les dispositifs destinés à mesurer la rotation magnéto-optique du plan de polarisation comprennent un deuxième polariseur (18),
(b) que le deuxième polariseur (18) est tourné de 45° par rapport au premier polariseur (17), et
(c) que le deuxième polariseur (18) est disposé sur l'autre extrémité du guide d'ondes (2b). (Figure 4)

12. Transducteur optique de courant conforme à la revendication 11, caractérisé par le fait
- que le deuxième polariseur (18) est intégré dans le substrat (1) à la place du premier polariseur (17).

13. Transducteur optique de courant conforme à la revendication 8, caractérisé par le fait
(a) qu'à l'une des extrémités du guide d'ondes (2a), derrière l'entrée optique (A), est disposé un premier polariseur (4,17) intégré dans le substrat,
(b) qu'il y a deux sorties optiques (B),
(c) que l'autre extrémité du guide d'ondes (2b) est reliée optiquement avec les deux sorties optiques (B) par le biais d'un coupleur en Y (5) intégré dans le substrat (1) côté sortie,
(d) que les dispositifs destinés à mesurer la rotation magnéto-optique du plan de polarisation comprennent un deuxième et un troisième polariseur (6, 7), et
(e) que le deuxième et le troisième polariseur (6, 7) sont disposés aux deux sorties optiques (B) orthogonalement l'un par rapport à l'autre et tournés de ± 45° par rapport au premier polariseur (4). (Figure 2b)

14. Transducteur optique de courant conforme à la revendication 1, caractérisé par le fait
(a) que le guide d'ondes (2) présente deux extrémités de guide d'ondes (2a, 2b),
(b) que l'une des extrémités du guide d'ondes (2a) est munie d'un miroir (8, 11), et
(c) que l'autre extrémité du guide d'ondes (2b) est reliée optiquement à l'entrée optique (A) et ladite au moins une sortie optique (B) de l'élément capteur (SE) par le biais d'un coupleur en Y (10, 12) intégré dans le substrat (1) côté entrée.

15. Transducteur optique de courant conforme à la revendication 14, caractérisé par le fait
(a) que dans l'une des branches du coupleur en Y (10) côté entrée derrière l'entrée optique (A), est disposé un premier polariseur (9) intégré dans le substrat (1),
(b) qu'il n'existe qu'une seule sortie optique (B),
(c) que l'autre branche du coupleur en Y (10) est reliée optiquement directement avec la sortie optique (B),
(d) que les dispositifs destinés à mesurer la rotation magnéto-optique du plan de polarisation comprennent un module de détection polarimétrique (19), et
(e) que le module de détection polarimétrique (19) est disposé derrière la sortie optique (B). (Figure 3a)

16. Transducteur optique de courant conforme à la revendication 14, caractérisé par le fait
(a) que dans l'une des branches du coupleur en Y (10) côté entrée derrière l'entrée optique (A), est disposé un premier polariseur (9) intégré dans le substrat (1),
(b) qu'il n'existe qu'une seule sortie optique (B),
(c) que l'autre branche du coupleur en Y (10) est reliée optiquement directement avec la sortie optique (B),
(d) que les dispositifs destinés à mesurer la rotation magnéto-optique du plan de polarisation comprennent un polariseur supplémentaire, et
(e) que le polariseur supplémentaire est tournée de 45° par rapport au premier polariseur (9) et qu'il est disposé derrière la sortie optique (B).

17. Transducteur optique de courant conforme à la revendication 14, caractérisé par le fait
(a) que dans l'une des branches du coupleur en Y (12) côté entrée derrière l'entrée optique (A), est disposé un premier polariseur (13) intégré dans le substrat (1),
(b) qu'il existe deux sorties optiques (B),
(c) que l'autre branche du coupleur en Y (12) est reliée optiquement avec les deux sorties optiques (B) par le biais d'un coupleur en y (14) intégré dans le substrat (1) côté sortie,
(d) que les dispositifs destinés à mesurer la rotation magnéto-optique du plan de polarisation comprennent un deuxième et un troisième polariseur (15, 16), et
(e) que le deuxième et le troisième polariseur (15, 16) sont disposés aux deux sorties optiques (B) orthogonalement l'un par rapport à l'autre et tournés de ± 45° par rapport au premier polariseur (13). (Figure 3b)

18. Transducteur optique de courant conforme à la revendication 1, caractérisé par le fait
(a) que le guide d'ondes (2) présente deux extrémités de guide d'ondes (2a, 2b),
(b) que les deux extrémités du guide d'ondes (2a, 2b) sont polies, et
(c) que le guide d'ondes (2) est utilisé comme résonateur.
